# EUROPEAN PATENT APPLICATION

(11) **EP 3 751 423 A2**
(43) Date of publication of application: **16.12.2020**
(21) Application number: 20166255.8
(22) Date of filing: 27.03.2020
(51) Int. Cl.: G06F 13/40, G06F 13/16, G06F 9/50, G06F 15/78, H01L 23/00, G11C 5/04, H01L 25/065

(54) **TECHNOLOGIES FOR ADDING COMPUTATIONAL ABILITY TO MEMORY DEVICES WITHOUT CHANGING MEDIA LAYERS**

(30) Priority: 10.06.2019 US 201916435861
(71) Applicant: INTEL Corporation, Santa Clara, CA 95054 (US)
(72) Inventor: KHAN, Jawad B., Santa Clara, CA 95054 (US); COULSON, Richard, Santa Clara, CA 95054 (US)
(74) Representative: Rummler, Felix

(57) **Abstract**

Technologies for adding computational ability to memory devices without changing media layers (610) include a process for the manufacture of a memory device. The process includes obtaining a memory media capable of communicating with multiple different types of media access circuitries (630) through a set of communication paths (620) at predefined locations (622, 624, 626, 628, 630, 632, 634). The process also includes obtaining a media access circuitry (630) capable of communicating with the memory media through the communication paths (620) at the predefined locations (622, 624, 626, 628, 630, 632, 634) and connecting the obtained memory media to the obtained media access circuitry (630) to enable communication through the communication paths (620) at the predefined locations (622, 624, 626, 628, 630, 632, 634).

## Description

### BACKGROUND

Generally, a memory of a compute device includes a memory media (e.g., a device or material on which data is retained) and media access circuitry (e.g., an integrated circuitry constructed from complementary metal-oxide-semiconductors (CMOS)) underneath the memory media. The media access circuitry underneath the memory media in typical memory devices does not have the ability to perform computational functions on the data in the memory media. Rather, to perform a computational function on the data, a processor of the compute device requests data from the memory, a bus between the memory and the processor transfers the data from the memory to the processor, the processor performs computational functions on the data to produce resulting data (e.g., output), and the bus transfers the resulting data back to the memory to be stored. The back-and-forth communication between the processor and the memory limits the speed at which computations on the data can be performed and consumes energy that could otherwise be used to perform other operations.

### BRIEF DESCRIPTION OF THE DRAWINGS

The concepts described herein are illustrated by way of example and not by way of limitation in the accompanying figures. For simplicity and clarity of illustration, elements illustrated in the figures are not necessarily drawn to scale. Where considered appropriate, reference labels have been repeated among the figures to indicate corresponding or analogous elements.
FIG. 1 is a simplified diagram of at least one embodiment of a compute device having a memory in which a memory media is connected, through a set of communication paths at defined locations, to a media access circuitry capable of performing a set of compute functions;
FIG. 2 is a simplified diagram of at least one embodiment of a memory media included in the compute device of FIG. 1;
FIG. 3 is a simplified diagram of at least one embodiment of a method for performing in-memory compute operations that may be performed by the memory of FIG. 1;
FIGS. 4-5 are simplified diagrams of at least one embodiment of a method for producing the memory of FIG. 1;
FIG. 6 is a side view of layers of a memory media, a physical socket defining communication paths, and a media access circuitry included in the compute device of FIG. 1;
FIG. 7 is a simplified diagram of at least one embodiment of a memory media access circuitry that may be connected to the memory media of the compute device of FIG. 1; and
FIG. 8 is a simplified diagram of at least one embodiment of a memory media access circuitry of a different type than the memory media access circuitry of FIG. 6 that may be connected to the memory media of the compute device of FIG. 1.

### DETAILED DESCRIPTION OF THE DRAWINGS

While the concepts of the present disclosure are susceptible to various modifications and alternative forms, specific embodiments thereof have been shown by way of example in the drawings and will be described herein in detail. It should be understood, however, that there is no intent to limit the concepts of the present disclosure to the particular forms disclosed, but on the contrary, the intention is to cover all modifications, equivalents, and alternatives consistent with the present disclosure and the appended claims.

References in the specification to "one embodiment," "an embodiment," "an illustrative embodiment," etc., indicate that the embodiment described may include a particular feature, structure, or characteristic, but every embodiment may or may not necessarily include that particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to effect such feature, structure, or characteristic in connection with other embodiments whether or not explicitly described. Additionally, it should be appreciated that items included in a list in the form of "at least one A, B, and C" can mean (A); (B); (C); (A and B); (A and C); (B and C); or (A, B, and C). Similarly, items listed in the form of "at least one of A, B, or C" can mean (A); (B); (C); (A and B); (A and C); (B and C); or (A, B, and C).

The disclosed embodiments may be implemented, in some cases, in hardware, firmware, software (e.g., instructions executable by a device (e.g., a processor), circuitry design data, semiconductor processing mask sets, databases for patterning machines for semiconductor processes before or after optical proximity correction has been applied, etc.) or any combination thereof. The disclosed embodiments may also be implemented as instructions carried by or stored on a transitory or non-transitory machine-readable (e.g., computer-readable) storage medium, which may be read and executed by one or more processors. A machine-readable storage medium may be embodied as any storage device, mechanism, or other physical structure for storing or transmitting information in a form readable by a machine (e.g., a volatile or non-volatile memory, a media disc, or other media device).

In the drawings, some structural or method features may be shown in specific arrangements and/or orderings. However, it should be appreciated that such specific arrangements and/or orderings may not be required. Rather, in some embodiments, such features may be arranged in a different manner and/or order than shown in the illustrative figures. Additionally, the inclusion of a structural or method feature in a particular figure is not meant to imply that such feature is required in all embodiments and, in some embodiments, may not be included or may be combined with other features.

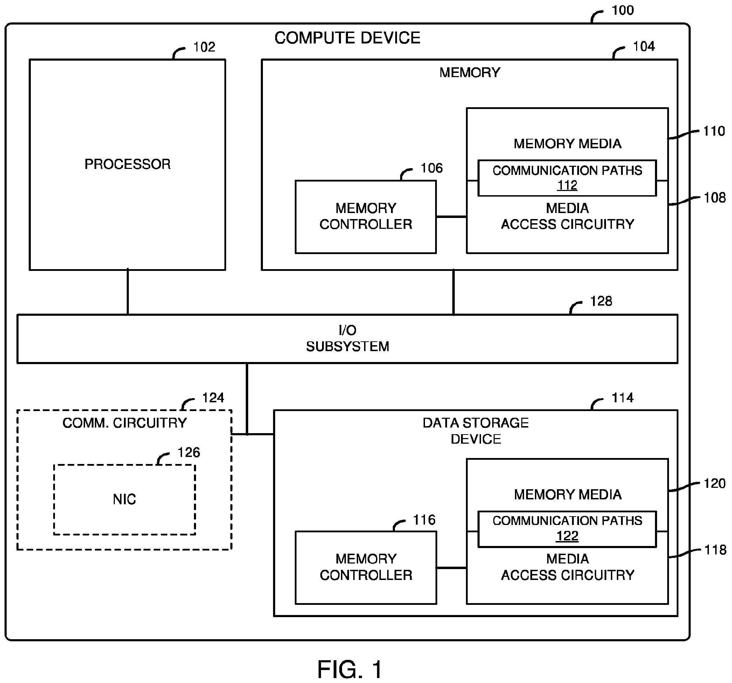

Referring now to FIG. 1, a compute device 100 for performing compute operations on a memory device includes a processor 102, a memory 104, a data storage device 114, an input/output (I/O) subsystem 128, and communication circuitry 124. It should be appreciated that, in other embodiments, the compute device 100 may include other or additional components, such as those commonly found in a computer (e.g., a display, peripheral devices, etc.). Additionally, in some embodiments, one or more of the illustrative components may be incorporated in, or otherwise form a portion of, another component. In the illustrative embodiment, the memory 104 of the compute device 100 includes a memory media 110 (e.g., any device or material that data is written to and read from) and media access circuitry 108 (e.g., any circuitry or device configured to access and operate on data in the corresponding memory media 110) underneath the memory media. For example, the media access circuitry 108 may be an integrated circuitry constructed from complementary metal-oxide-semiconductors (CMOS). Typically, the media access circuitry 108 underneath the memory array in typical memory devices does not have computational ability (e.g., an ability to perform one or more computational functions, such as matrix multiplication, matrix addition, matrix subtraction, stochastic associative search operations, neural network operations, such as training or producing inferences with a neural network, etc., on data residing in the memory media 110). However, in the illustrative embodiment, the media access circuitry 108 underneath the memory media 110 does provide computational ability. Furthermore, the same memory media 110 may be connected, through a set of communication paths 112 (e.g., vias, pins, or other components configured to provide an electrical connection to enable communication of data) at predefined locations (e.g., between the memory media 110 and the media access circuitry 108), to different types of media access circuitries 108 (e.g., one media access circuitry 108 that has one size and architecture, and may implement computational function A, another media access circuitry 108 that has a different size and architecture, and may implement computational functions B and C, etc.). As such, the layout of the memory media 110 need not be changed to accommodate one type of media access circuitry 108 versus another type of media access circuitry 108, thereby making the production (e.g., design and manufacturing) of memories 104 having different computational abilities more efficient than it would otherwise be. Further, by supporting compute operations in the memory 104, the compute device 100 may perform operations more efficiently (e.g., in terms of time and power usage) than conventional compute devices that send data through a bus between a memory and a processor to perform compute operations.

The processor 102 may be embodied as any device or circuitry (e.g., a multicore processor(s), a microcontroller, or other processor or processing/controlling circuit) capable of executing a workload (e.g., a set of operations, such as an application that may produce requests to read from and/or write to sections of memory, such as selected columns and/or rows of data in a matrix, and/or send a request to the memory 104 to perform an in-memory compute operation (e.g., using the media access circuitry 108)), and/or performing other operations described herein. In some embodiments, the processor 102 may be embodied as, include, or be coupled to a field-programmable gate array (FPGA), an application specific integrated circuit (ASIC), reconfigurable hardware or hardware circuitry, or other specialized hardware to facilitate performance of the functions described herein.

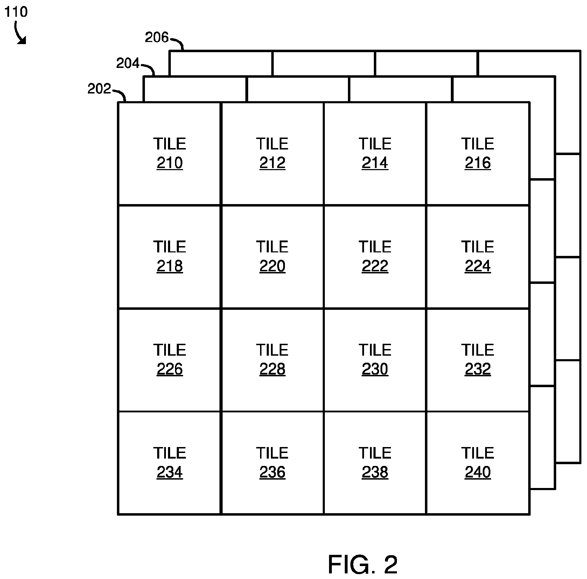

The memory 104, which may include a non-volatile memory (e.g., a far memory in a two-level system main memory scheme), includes the memory media 110, media access circuitry 108 (e.g., a device or circuitry, such as integrated circuitry constructed from complementary metal-oxide-semiconductors (CMOS) or other materials) underneath the memory media 110, and the communication paths 112, described above. Referring briefly to FIG. 2, the memory media 110, in the illustrative embodiment, includes a tile architecture, also referred to herein as a cross point architecture (e.g., an architecture in which memory cells sit at the intersection of word lines and bit lines and are individually addressable and in which bit storage is based on a change in bulk resistance), in which each memory cell (e.g., tile) 210, 212, 214, 216, 218, 220, 222, 224, 226, 228, 230, 232, 234, 236, 238, 240 is addressable by an x parameter and a y parameter (e.g., a column and a row). The memory media 110 includes multiple partitions, each of which includes the tile architecture. The partitions may be stacked as layers 202, 204, 206 to form a three-dimensional cross point architecture (e.g., Intel 3D XPoint™ memory, Intel Optane™ memory, or Micron QuantX™ memory). Unlike typical memory devices, in which only fixed-size multiple-bit data structures (e.g., byte, words, etc.) are addressable, the media access circuitry 108 is configured to read individual bits, or other units of data, from the memory media 110 at the request of a memory controller 106, which may produce the request in response to receiving a corresponding request from the processor 102.

Referring back to FIG. 1, the media access circuitry 108 is also connected to a memory controller 106, which may be embodied as any device or circuitry (e.g., a processor, a co-processor, dedicated circuitry, etc.) configured to selectively read from and/or write to the memory media 110 (e.g., in response to requests from the processor 102, which may be executing an application seeking to read from or write to the memory media 110) and to issue requests (e.g., from the processor 102) to the media access circuitry 108 to perform one or more computational function(s) on data in the memory media 110. In some embodiments, the memory controller 106 is included in the same die as the media access circuitry 108. In other embodiments, the memory controller 106 may be on a separate die but in the same package as the media access circuitry 108. In yet other embodiments, the memory controller 106 may be in a separate die and separate package but on the same dual in-line memory module (DIMM) or board as the media access circuitry 108.

Additionally, in the illustrative embodiments, the memory controller 106 is configured to determine, in response to a receipt of a compute request from a requestor (e.g., the processor 102, etc.), whether the media access circuitry 108 is capable of performing the compute request (e.g., by querying the media access circuitry 108 to determine whether the requested function is supported, by comparing a type identifier (e.g., any data indicative of the type) of the media access circuitry 108 to a data set of computational functions supported by different types of media access circuitries, etc.). As discussed further below, the media access circuitry 108 has the ability to perform a set of defined computational functions (also referred to as compute operations). If the media access circuitry 108 is capable of performing the compute request, the memory controller 106 may further be configured to write resulting data (e.g., the result of a requested compute operation) to the memory media 110.

The main memory 104 may also include any type of volatile (e.g., dynamic random access memory (DRAM), etc.) or non-volatile memory or data storage capable of performing the functions described herein. Volatile memory may be a storage medium that requires power to maintain the state of data stored by the medium. Non-limiting examples of volatile memory may include various types of random access memory (RAM), such as dynamic random access memory (DRAM) or static random access memory (SRAM). One particular type of DRAM that may be used in a memory module is synchronous dynamic random access memory (SDRAM). In particular embodiments, DRAM of a memory component may comply with a standard promulgated by JEDEC, such as JESD79F for DDR SDRAM, JESD79-2F for DDR2 SDRAM, JESD79-3F for DDR3 SDRAM, JESD79-4A for DDR4 SDRAM, JESD209 for Low Power DDR (LPDDR), JESD209-2 for LPDDR2, JESD209-3 for LPDDR3, and JESD209-4 for LPDDR4. In some embodiments, the memory 104 may include DDR5, DDR6, LPDDR5. LPDDR6, or other types of memory. Such standards (and similar standards) may be referred to as DDR-based standards and communication interfaces of the storage devices that implement such standards may be referred to as DDR-based interfaces.

In some embodiments, the memory 104, may also include a block addressable memory device, such as those based on NAND or NOR technologies. In some embodiments, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a DW (Domain Wall) and SOT (Spin Orbit Transfer) based device, a thyristor based memory device, or a combination of any of the above, or other memory. The memory device may refer to the die itself and/or to a packaged memory product.

The processor 102 and the memory 104 are communicatively coupled to other components of the compute device 100 via the I/O subsystem 128, which may be embodied as circuitry and/or components to facilitate input/output operations with the processor 102 and/or the main memory 104 and other components of the compute device 100. For example, the I/O subsystem 128 may be embodied as, or otherwise include, memory controller hubs, input/output control hubs, integrated sensor hubs, firmware devices, communication links (e.g., point-to-point links, bus links, wires, cables, light guides, printed circuit board traces, etc.), and/or other components and subsystems to facilitate the input/output operations. In some embodiments, the I/O subsystem 128 may form a portion of a system-on-a-chip (SoC) and be incorporated, along with one or more of the processor 102, the main memory 104, and other components of the compute device 100, in a single chip.

The data storage device 114, may be embodied as any type of device configured for short-term or long-term storage of data such as, for example, memory devices and circuits, memory cards, hard disk drives, solid-state drives, or other data storage device. In the illustrative embodiment, the data storage device 114 includes a memory controller 116, similar to the memory controller 106, media access circuitry 118, similar to the media access circuitry 108, memory media 120, similar to the memory media 110, and communication paths 122, similar to the communication paths 112. As such, in the illustrative embodiment, the data storage device 114 is capable of performing a set of in-memory compute operations (e.g., operations supported by the media access circuitry 118). The data storage device 114 may include a system partition that stores data and firmware code for the data storage device 114 and one or more operating system partitions that store data files and executables for operating systems.

The communication circuitry 124 may be embodied as any communication circuit, device, or collection thereof, capable of enabling communications over a network between the compute device 100 and another device. The communication circuitry 124 may be configured to use any one or more communication technology (e.g., wired or wireless communications) and associated protocols (e.g., Ethernet, Bluetooth®, Wi-Fi®, WiMAX, etc.) to effect such communication.

The illustrative communication circuitry 124 includes a network interface controller (NIC) 126, which may also be referred to as a host fabric interface (HFI). The NIC 126 may be embodied as one or more add-in-boards, daughter cards, network interface cards, controller chips, chipsets, or other devices that may be used by the compute device 100 to connect with another compute device. In some embodiments, the NIC 126 may be embodied as part of a system-on-a-chip (SoC) that includes one or more processors, or included on a multichip package that also contains one or more processors. In some embodiments, the NIC 126 may include a local processor (not shown) and/or a local memory (not shown) that are both local to the NIC 126. In such embodiments, the local processor of the NIC 126 may be capable of performing one or more of the functions of the processor 102. Additionally or alternatively, in such embodiments, the local memory of the NIC 126 may be integrated into one or more components of the compute device 100 at the board level, socket level, chip level, and/or other levels.

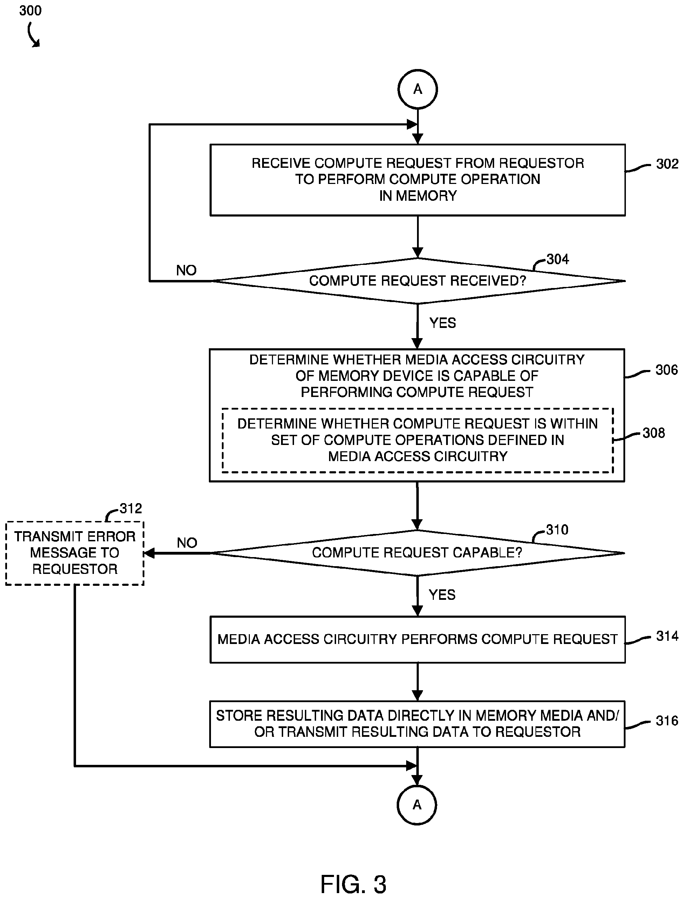

Referring now to FIG. 3, the memory 104 of the compute device 100, in operation, may execute a method 300 for performing in-memory compute operations. The method 300 is described with reference to the memory 104. However, it should be understood that the method 300 could be additionally or alternatively performed using the memory of the data storage device 114. The method 300 begins with block 302, in which the memory controller 106 of the memory 104 may receive a compute request from a requestor to perform a compute operation in the memory 104. For example, the memory controller 106 may receive a request from the processor 102, which may be executing an application that would benefit from having a compute operation (e.g., a matrix multiplication, a stochastic associative search, a neural network training or inference-producing operation, etc.) performed on data present in the memory media 110. In block 304, the memory controller 106 determines the subsequent course of action based on whether a request was received in block 302. If not, the method 300 loops back to block 302 to await a request to perform a compute operation in memory. Otherwise, (e.g., if a compute request has been received), the method 300 advances to block 306.

In block 306, the memory controller 106 determines whether the media access circuitry 108 of the memory 104 is capable of performing the compute request. To do so, and as indicated in block 308, the memory 104 may determine whether the compute operation(s) required to perform the compute request is within a set of compute operations defined in the media access circuitry 108 (e.g., in an application specific integrated circuit (ASIC) and/or other circuitry in the media access circuitry 108). For example, the memory controller 106 may query the media access circuitry 108 to determine whether the requested function is supported. In other embodiments, the media access circuitry 108 may compare a type identifier (e.g., readable from a register) of the media access circuitry 108 to a data set of computational functions supported by different types of media access circuitries. In other embodiments, the memory controller 106 may make the determination of whether the compute request is within the set of compute operations defined in the media access circuitry 108 based on other factors. Regardless, in block 310, the memory controller 106 determines the subsequent course of action based on whether the media access circuitry 108 is capable of performing the compute request. If the memory controller 106 determines that the media access circuitry 108 is not capable of performing the compute request, the method 300 may advance to block 312. In block 312, the memory controller 106 may transmit an error message to the requestor (e.g., to the processor 102) indicating that the compute request cannot be performed by the memory 104. If, however, the memory controller 106 determines that the media access circuitry 108 is capable of performing the compute request, the method 300 advances to block 314.

In block 314, the media access circuitry 108 performs the compute request. To do so, the media access circuitry 108 may access data in the memory media 110 and perform one or more compute operations (e.g., matrix multiplication, stochastic associative search, neural network operation(s), etc.) on the accessed data to satisfy the compute request. In the illustrative embodiment, the media access circuitry 108 may access data using columns and rows of data arranged in the memory media 110. Alternatively, in some embodiments, the requestor (e.g., the processor 102) may provide the data to the memory 104 with the compute request.

Subsequently, in block 316, the media access circuitry 108 may store resulting data directly in the memory media 110 and/or transmit the resulting data to the requestor, as instructed in the compute request. It should be appreciated that, although blocks 302-316 are described as being executed by the memory controller 106, one or more of the blocks 302-316 may be performed by a different component of the memory 104.

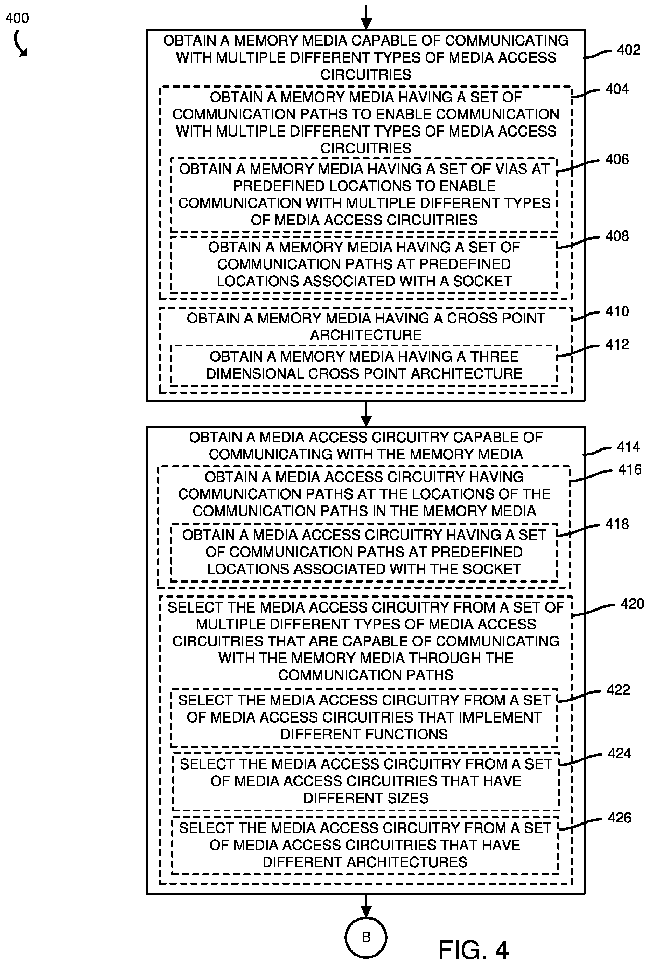

Referring now to FIG. 4, a producer of memory devices may execute a method 400 for producing a memory in which a memory media having a single layout is connectable to one of a variety of media access circuitries that may have differing sizes, architectures, and/or computational capabilities. The method 400 begins with block 402, in which the producer obtains (e.g., designs, selects, manufactures) a memory media capable of communicating with multiple different types of media access circuitries. In doing so, the producer obtains a memory media having a set of communication paths to enable communication with multiple different types of media access circuitries, as indicated in block 404. As indicated in block 406, the producer may obtain a memory media having a set of vias at predefined locations to enable communication with multiple different types of media access circuitries. The producer may obtain a memory media having a set of communication paths at predefined locations associated with a socket (e.g., a physical socket, which may be embodied as any device capable of electrically and mechanically connecting and aligning multiple components together), as indicated in block 408. In obtaining the memory media, the producer may obtain a memory media having a cross point architecture (e.g., an architecture in which memory cells sit at the intersection of word lines and bit lines and are individually addressable and in which bit storage is based on a change in bulk resistance), as indicated in block 410. Further, in doing so, the producer may obtain a memory media having a three dimensional cross point architecture (e.g., an architecture in which sets of tiles are stacked as layers, as described with reference to FIG. 2), as indicated in block 412.

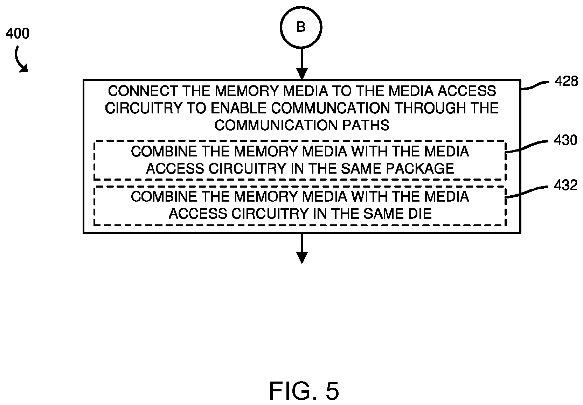

Additionally, and as indicated in block 414, the producer obtains a media access circuitry capable of communicating with the memory media (e.g., the memory media obtained in block 402). In doing so, the producer, in the illustrative embodiment, obtains a media access circuitry having communication paths at the locations of (e.g., at locations that align with) the communication paths of the memory media from block 402, as indicated in block 416. In the illustrative embodiment, and as indicated in block 418, the producer obtains a media access circuitry having a set of communication paths at predefined locations associated with the socket described with reference to block 408. In block 420, in obtaining the media access circuitry, the producer may select the media access circuitry from a set of multiple different types of media access circuitries that are capable of communication with the memory media (e.g., from block 402) through the communication paths. As indicated in block 422, the producer may select the media access circuitry from a set of media access circuitries that implement (e.g., are capable of executing) different functions (e.g., compute operations) on data in the memory media. As indicated in block 424, the producer may select the media access circuitry from a set of media access circuitries that have different sizes. Similarly, and as indicated in block 426, the producer may select the media access circuitry from a set of media access circuitries that have different architectures (e.g., different layouts of components). In selecting a media access circuitry, the producer may select or design a mask for, and subsequently fabricate, using the mask, the media access circuitry. Alternatively, the producer may select an already-manufactured media access circuitry. Regardless, after the producer has obtained the memory media and the media access circuitry, the method 400 advances to block 428 of FIG. 5, in which the producer connects the obtained memory media (e.g., the memory media 110) to the obtained media access circuitry (e.g., the media access circuitry 108) to enable communication through the communication paths (e.g., the communication paths 112).

Referring now to FIG. 5, in connecting the memory media to the media access circuitry, the producer may combine the memory media with the media access circuitry in the same package (e.g., the same semiconductor package), as indicated in block 430. Similarly, and as indicated in block 432, the producer may combine the memory media with the media access circuitry in the same die (e.g., the same semiconductor die).

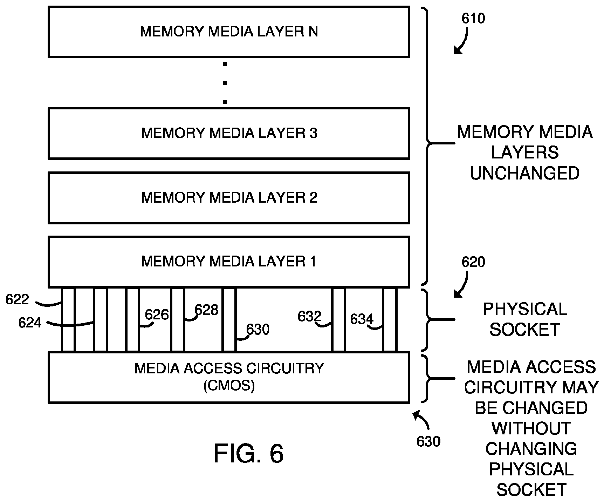

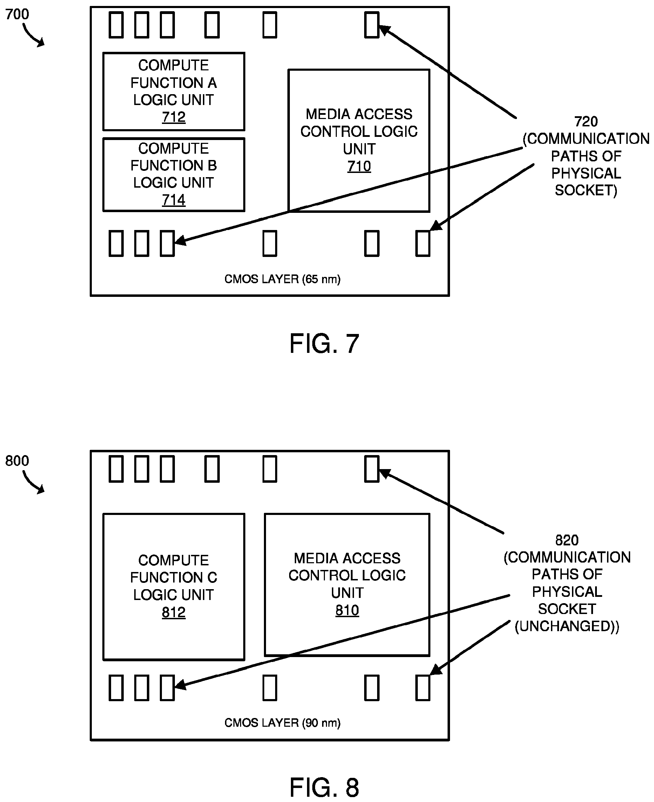

Referring briefly to FIG. 6, a memory media 610, similar to the memory medias 110, 120 is formed from a set of layers (e.g., layers 1 through N), similar to the layers 202, 204, 206 of FIG. 2. Further, a set of communication paths 622, 624, 626, 628, 630, 632, 634, similar to the communication paths 112, 122, at predefined locations and associated with a socket (e.g., the socket 620) enable the memory media 610 to communicate with any media access circuitry 630 that is laid out to communicate through the communication paths 622, 624, 626, 628, 630, 632, 634 at the predefined locations. As such, different memories may be produced having different computational abilities (e.g., different media access circuitries) while using the same layout for the memory media 610, thereby vastly simplifying the production (e.g., design and manufacturing process) of the memories. Referring briefly to FIG. 7, one media access circuitry 700 has three logic units 710, 712, 714 (e.g., integrated circuits). More specifically, the logic unit 710 is capable of performing memory accesses (e.g., read and write), the logic unit 712 is capable of performing compute function A (e.g., stochastic associative search) and the logic unit 714 is capable of performing compute function B (e.g., performing a neural network operation). The media access circuitry 700 is configured to communicate with the memory media 610 through the communication paths 720. Referring briefly to FIG. 8, another media access circuitry 800 of a different type (e.g., different architecture, different set of functions) than the media access circuitry 700 includes two logic units 810, 812. The logic unit 810 is capable of performing memory accesses (e.g., read and write) and the logic unit 812 is capable of performing compute function C (e.g., a matrix operation, such as a matrix multiplication operation). Importantly, while the two media access circuitries 700, 800 are of different types, their respective communication paths 720, 820 are at the locations defined by the socket 620 and, as such, enable either of them to be communicatively coupled to the memory media 610 during production.

### EXAMPLES

Illustrative examples of the technologies disclosed herein are provided below. An embodiment of the technologies may include any one or more, and any combination of, the examples described below.
Example 1 includes a memory comprising a memory media having a set of communication paths usable to enable communication between the memory media and multiple different types of media access circuitries.
Example 2 includes the subject matter of Example 1, and wherein the set of communication paths are usable to enable communication between the memory media and media access circuitries configured to implement different functions on data in the memory media.
Example 3 includes the subject matter of any of Examples 1 and 2, and wherein the set of communication paths are usable to enable communication between the memory media and media access circuitries that have different sizes.
Example 4 includes the subject matter of any of Examples 1-3, and wherein the set of communication paths are usable to enable communication between the memory media and media access circuitries that have different architectures.
Example 5 includes the subject matter of any of Examples 1-4, and wherein the set of communication paths are vias.
Example 6 includes the subject matter of any of Examples 1-5, and wherein memory media has a cross point architecture.
Example 7 includes the subject matter of any of Examples 1-6, and wherein the memory media has a three dimensional cross point architecture.
Example 8 includes the subject matter of any of Examples 1-7, and wherein the set of communication paths are at predefined locations associated with a socket.
Example 9 includes the subject matter of any of Examples 1-8, and further including one of the different types of media access circuitries connected to the memory media through the set of communication paths.
Example 10 includes the subject matter of any of Examples 1-9, and wherein the one of the media access circuitries is formed from a complementary metal-oxide-semiconductor (CMOS).
Example 11 includes the subject matter of any of Examples 1-10, and wherein the memory media and the media access circuitry are in the same semiconductor die.
Example 12 includes a method comprising receiving, by a memory that includes a memory media connected to a media access circuitry through a set of communication paths usable to enable communication between the memory media and multiple different types of media access circuitries, a compute request to perform a function on data in the memory media; determining, in response to receiving the compute request and by the memory, whether the media access circuitry connected to the memory media is capable of performing the function on the data in the memory media; and performing, in response to a determination that the media access circuitry connected to the memory media is capable of performing the function, the function on the data in the memory media.
Example 13 includes the subject matter of Example 12, and further including writing, by the media access circuitry connected to the memory media, resulting data to the memory media.
Example 14 includes the subject matter of any of Examples 12 and 13, and further including transmitting, in response to a determination that the media access circuitry connected to the memory media is not capable of performing the function, an error message to another component of a compute device in which the memory is located.
Example 15 includes a process for the manufacture of a memory, the process comprising obtaining a memory media capable of communicating with multiple different types of media access circuitries through a set of communication paths at predefined locations; obtaining a media access circuitry capable of communicating with the memory media through the communication paths at the predefined locations; and connecting the obtained memory media to the obtained media access circuitry to enable communication through the communication paths at the predefined locations.
Example 16 includes the subject matter of Example 15, and wherein connecting the obtained memory media to the obtained media access circuitry comprises combining the obtained memory media with the obtained media access circuitry in the same semiconductor die.
Example 17 includes the subject matter of any of Examples 15 and 16, and wherein obtaining the memory media comprises obtaining a memory media having a cross point architecture.
Example 18 includes the subject matter of any of Examples 15-17, and wherein obtaining the memory media comprises obtaining a memory media having a three dimensional cross point architecture.
Example 19 includes the subject matter of any of Examples 15-18, and wherein to obtain the media access circuitry comprises to select the media access circuitry from a set of media access circuitries that implement different functions.
Example 20 includes the subject matter of any of Examples 15-19, and wherein to obtain the media access circuitry comprises to select the media access circuitry from a set of media access circuitries that have different sizes or different architectures.

## Claims

1. A memory comprising:
a memory media having a set of communication paths usable to enable communication between the memory media and multiple different types of media access circuitries.

2. The memory of claim 1, wherein the set of communication paths are usable to enable communication between the memory media and media access circuitries configured to implement different functions on data in the memory media.

3. The memory of claim 1, wherein the set of communication paths are usable to enable communication between the memory media and media access circuitries that have different sizes.

4. The memory of claim 1, wherein the set of communication paths are usable to enable communication between the memory media and media access circuitries that have different architectures.

5. The memory of claim 1, wherein the set of communication paths are vias.

6. The memory of claim 1, wherein memory media has a cross point architecture.

7. The memory of claim 6, wherein the memory media has a three dimensional cross point architecture.

8. The memory of claim 1, wherein the set of communication paths are at predefined locations associated with a socket.

9. The memory of claim 1, further comprising one of the different types of media access circuitries connected to the memory media through the set of communication paths.

10. The memory of claim 9, wherein the one of the media access circuitries is formed from a complementary metal-oxide-semiconductor (CMOS).

11. The memory of claim 9, wherein the memory media and the media access circuitry are in the same semiconductor die.

12. A method comprising:
receiving, by a memory that includes a memory media connected to a media access circuitry through a set of communication paths usable to enable communication between the memory media and multiple different types of media access circuitries, a compute request to perform a function on data in the memory media;
determining, in response to receiving the compute request and by the memory, whether the media access circuitry connected to the memory media is capable of performing the function on the data in the memory media; and
performing, in response to a determination that the media access circuitry connected to the memory media is capable of performing the function, the function on the data in the memory media.

13. The method of claim 12, further comprising transmitting, in response to a determination that the media access circuitry connected to the memory media is not capable of performing the function, an error message to another component of a compute device in which the memory is located.

14. One or more machine-readable storage media comprising a plurality of instructions stored thereon that, when executed, causes a memory to perform the method of any of claims 12-13.

15. A memory comprising means for performing the method of any of claims 12-13.
